(19) **Europäisches Patentamt / European Patent Office / Office européen des brevets**

(11) **EP 3 656 131 B1**

(12) **FASCICULE DE BREVET EUROPEEN**

(45) Date de publication et mention de la délivrance du brevet:
**10.03.2021 Bulletin 2021/10**

(51) Int Cl.:
*H04Q 9/00* *(2006.01)* *G01R 22/00* *(2006.01)*

(21) Numéro de dépôt: **18737289.1**

(86) Numéro de dépôt international:
**PCT/EP2018/068851**

(22) Date de dépôt: **11.07.2018**

(87) Numéro de publication internationale:
**WO 2019/016053 (24.01.2019 Gazette 2019/04)**

(54) **PROCÉDÉ DE RELEVÉ D'INFORMATIONS D'UN ENSEMBLE DE COMPTEURS ÉLECTRIQUES**

VERFAHREN ZUR INFORMATIONSAUFZEICHNUNG AUS EINEM SATZ ELEKTRISCHER MESSGERÄTE

METHOD FOR RECORDING INFORMATION FROM A SET OF ELECTRIC METERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.07.2017 FR 1756855**
**06.12.2017 FR 1761725**

(43) Date de publication de la demande:
**27.05.2020 Bulletin 2020/22**

(73) Titulaire: **Sagemcom Energy & Telecom SAS**
**92500 Rueil-Malmaison (FR)**

(72) Inventeurs:
• **TEBOULLE, Henri**
  **92500 Rueil Malmaison (FR)**
• **BAROIS, Jérôme**
  **92500 Rueil Malmaison (FR)**
• **BARTHES, Julien**
  **92500 Rueil Malmaison (FR)**
• **ROTER, Ziv**
  **92500 Rueil Malmaison (FR)**

(74) Mandataire: **Cabinet Le Guen Maillet**
**3, impasse de la Vigie**
**CS 71840**
**35418 Saint-Malo Cedex (FR)**

(56) Documents cités:
**FR-A1- 2 871 981          US-A1- 2014 077 970**
**US-A1- 2015 296 277**

**Description**

La présente invention concerne un procédé de relevé d'informations d'un ensemble de compteurs électriques reliés par un réseau d'alimentation électrique à un concentrateur de données avec lequel lesdits compteurs électriques communiquent par courant porteur en ligne et un dispositif mettant en œuvre le procédé.

Les communications par courants porteurs en ligne (CPL) (« PowerLine Communications (PLC) » en terminologie anglo-saxonne) se développent, notamment dans le cadre des réseaux d'alimentation électrique de type AMM (Gestion de mesure automatique, « Automated Meter Management » en terminologie anglo-saxonne). Des réseaux de communication sont ainsi implémentés au-dessus de réseaux d'alimentation électrique pour la collecte automatisée, auprès de compteurs électriques intelligents (« smart meters » en terminologie anglo-saxonne), de données de relevés de consommation énergétique. Les communications par courants porteurs utilisent, par exemple, des protocoles de communication CPL tels que le protocole G3-PLC (CPL de troisième génération: « Third Generation PLC » en terminologie anglo-saxonne. ITU-T G.9903) ou PRIME (Evolution des mesures intelligentes par courants porteurs, « PoweRline Intelligent Metering Evolution » en terminologie anglo-saxonne).

Un principe des communications CPL consiste à superposer à un signal d'alimentation électrique alternatif, appelé *signal porteur* ou *porteuse,* un signal d'information de plus haute fréquence et de faible énergie représentatif de données à transmettre.

Avec ce développement des réseaux d'alimentation électrique de type AMM, que nous appelons *réseaux CPL* par la suite, se posent de nouveaux problèmes. Notamment, les réseaux CPL comportent maintenant un grand nombre de compteurs électriques pour lesquels un relevé d'informations (par exemple de courbes de charge) doit être effectué dans un minimum de temps. Dans le fonctionnement actuel des réseaux CPL, les relevés d'informations des compteurs électriques se font sans distinguer les compteurs électriques. Ces réseaux utilisant une méthode d'accès au medium de type CSMA/CA (accès multiple au medium avec évitement de collision, « Carrier Sense Multiple Access with Collision Avoidance » en terminologie anglo-saxonne) au niveau MAC (Contrôle d'accès au médium, « Médium Access Control » en terminologie anglo-saxonne), la non-distinction des compteurs électriques induit beaucoup de temps de contention, ce qui a pour effet de ralentir le relevé des informations des compteurs. En effet, dans les réseaux de type CSMA/CA, chaque dispositif émetteur écoute le médium afin de déterminer si ce médium est libre pour que ledit dispositif émetteur puisse transmettre ses propres données. Si le dispositif émetteur détecte que le médium est libre, il transmet ses données. Si au même moment, un autre dispositif émetteur émet des données sur le médium, les données se collisionnent. Dans ce cas, les deux dispositifs émetteurs déterminent une durée aléatoire au bout de laquelle ils réécouteront le médium et feront une tentative de transmission si le médium est libre. Cette durée aléatoire est appelée temps (ou période) de contention. Il est préférable de minimiser le temps passé par les dispositifs émetteurs dans des périodes de contention pour éviter de ralentir les communications. On comprend en effet aisément que des communications de données qui se font directement, sans passer par des périodes de contention, sont plus rapides.

Des méthodes de type TDM (multiplexage par division temporelle, « time division multiplexing » en terminologie anglo-saxonne) existent pour éviter que les compteurs électriques transmettent des informations au même moment. Toutefois, les méthodes de type TDM ont l'inconvénient de nécessiter de synchroniser tous les compteurs électriques entre eux.

Il est souhaitable de pallier ces inconvénients de l'état de la technique. Il est notamment souhaitable de proposer une méthode qui permette de relever un maximum de compteurs dans un minimum de temps. Il est particulièrement souhaitable que cette méthode minimise le temps de contention sur le réseau.

Il est de plus souhaitable de fournir une solution qui soit simple à mettre en œuvre et à faible coût.

La demande de brevet US 2014/0077970 décrit un concentrateur de données qui lit des données en classant, en fonction de la phase, des compteurs électriques dans une pluralité de groupes de lecture.

La demande de brevet FR 2 871 981 décrit un procédé de lecture à distance d'un ensemble de compteurs électriques qui tient compte d'une information géographique relative à chaque compteur.

La demande de brevet US 2015/296277 décrit un appareil de communication par ligne électrique triphasée et son procédé de communication.

L'invention est définie par les revendications indépendantes 1, 13. Des modes de réalisation préférés de l'invention sont stipulés dans les revendications dépendantes.

Bien que plusieurs modes de réalisation et/ou exemples aient été divulgués dans la description, l'objet pour lequel la protection est demandée est strictement et uniquement limité aux modes de réalisation et/ou exemples compris dans le champ d'application des revendications annexées. Les modes de réalisations et/ou les exemples mentionnés dans la description qui n'entrent pas dans le champ d'application des revendications sont utiles pour comprendre l'invention.

Les caractéristiques de l'invention apparaîtront plus clairement à la lecture de la description suivante d'un exemple de réalisation, ladite description étant faite en relation avec les dessins joints, parmi lesquels :

- la Fig. 1 illustre schématiquement un exemple de réseau d'alimentation électrique de type AMM dans lequel est mise en œuvre l'invention;
- la Fig. 2 illustre schématiquement un exemple d'architecture matérielle d'un dispositif mettant en œuvre le procédé selon l'invention ;
- la Fig. 3 illustre schématiquement un premier exemple de procédé de relevé d'informations de compteurs électriques selon l'invention ; et,
- La Fig. 4 illustre schématiquement un deuxième exemple de procédé de relevé d'informations de compteurs électriques selon l'invention.

Par la suite, l'invention est décrite dans un contexte où le protocole de communication CPL utilisé dans un réseau CPL dans lequel est mise en œuvre l'invention est le protocole G3-PLC. L'invention peut toutefois être mise en œuvre dans un réseau CPL dans lequel les communications CPL utilisent le protocole PRIME.

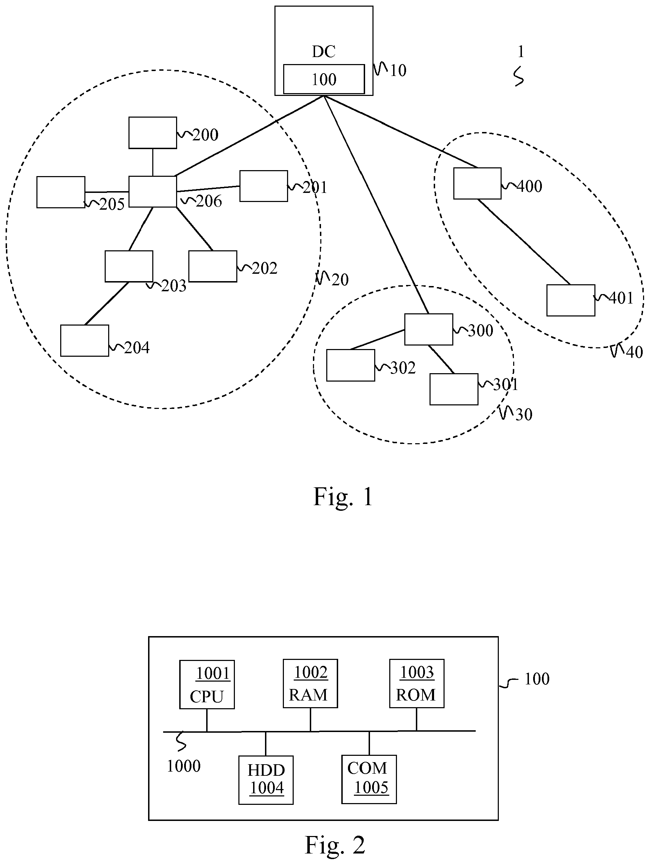

La **Fig. 1** illustre schématiquement un exemple de réseau d'alimentation électrique de type AMM (*i.e.* un réseau CPL) dans lequel est mise en œuvre l'invention.

Le réseau CPL 1 comprend un concentrateur de données (« data concentrator » en terminologie anglo-saxonne) 10 auquel sont reliés directement ou indirectement un ensemble de compteurs électriques, appelés simplement *compteurs* par la suite. Les compteurs sont regroupés en trois groupes. Un premier groupe 20 comprenant des compteurs 200 à 206 correspond à une zone dense du réseau CPL 1. Une zone dense comprend des compteurs ayant beaucoup de voisins dans leur voisinage, *i.e.* ayant un nombre de voisins dans leur voisinage supérieur ou égal à un premier seuil. Dans un mode de réalisation, un premier compteur est considéré comme appartenant au voisinage d'un deuxième compteur si le deuxième compteur reçoit des trames du premier compteur. Un deuxième groupe 30 comprend des compteurs 300 à 302 et correspond à une zone moyennement dense du réseau CPL 1. Une zone moyennement dense comprend des compteurs ayant un nombre de voisins dans leur voisinage inférieur au premier seuil et supérieur ou égal à un deuxième seuil. Un troisième groupe 40 comprend des compteurs 400 et 401 et correspond à une zone peu dense du réseau CPL 1. Une zone peu dense comprend des compteurs ayant un nombre de voisins dans leur voisinage inférieur au deuxième seuil.

Le concentrateur de données 10 comprend un module de traitement 100 mettant en œuvre le procédé selon l'invention. Le module de traitement 100 peut être intégré nativement au concentrateur de données 10 ou avoir été branché sur le concentrateur de données 10, par exemple sur un port USB (bus série universel, « Universal Serial Bus » en terminologie anglo-saxonne) dudit concentrateur de données 10. Le module de traitement 100 peut aussi être un module logiciel.

La **Fig. 2** illustre schématiquement un exemple d'architecture matérielle du module de traitement 100 du concentrateur de données 10. Le module de traitement 100 comprend alors, reliés par un bus de communication 1000: un processeur ou CPU (« Central Processing Unit » en terminologie anglo-saxonne) 1001 ; une mémoire vive RAM (« Random Access Memory » en terminologie anglo-saxonne) 1002; une mémoire morte ROM (« Read Only Memory » en terminologie anglo-saxonne) 1003 ; une unité de stockage ou un lecteur de support de stockage, tel qu'un lecteur de cartes SD (« Secure Digital » en terminologie anglo-saxonne) 1004 ; un ensemble d'interfaces de communication 1005 permettant au module de traitement 100 de communiquer avec d'autres modules du concentrateurs de données 10 ou avec des compteurs du réseau CPL 1.

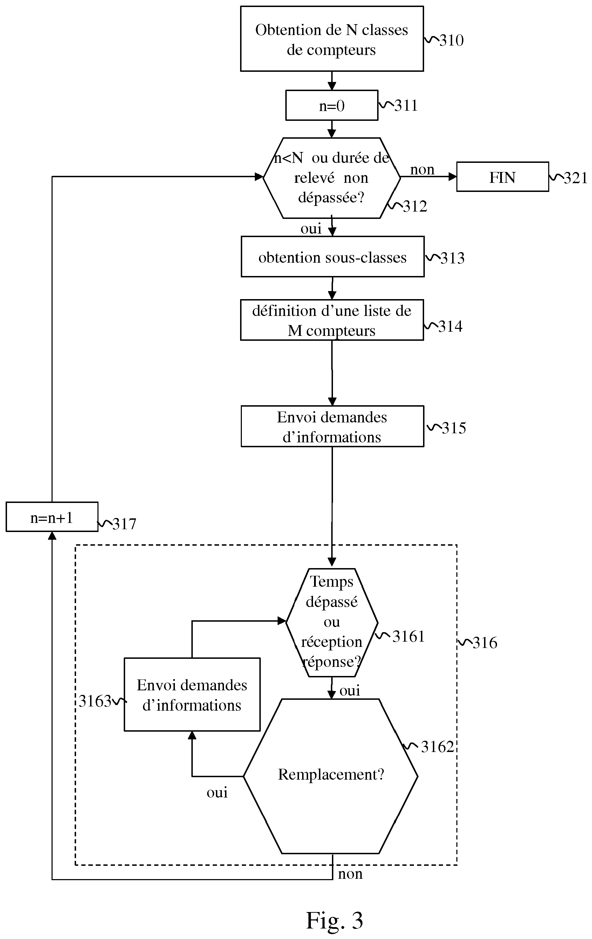

Le processeur 1001 est capable d'exécuter des instructions chargées dans la RAM 1002 à partir de la ROM 1003, d'une mémoire externe (non représentée), d'un support de stockage, tel qu'une carte SD, ou d'un réseau de communication. Lorsque le concentrateur de données 10 est mis sous tension, le processeur 1001 est capable de lire de la RAM 1002 des instructions et de les exécuter. Ces instructions forment un programme d'ordinateur causant la mise en œuvre, par le processeur 1001, du procédé décrit en relation avec la Fig. 3.

Tout ou partie du procédé décrit en relation avec la Fig. 3 peut être implémenté sous forme logicielle par exécution d'un ensemble d'instructions par une machine programmable, telle qu'un DSP (« Digital Signal Processor » en terminologie anglo-saxonne) ou un microcontrôleur, ou être implémenté sous forme matérielle par une machine ou un composant dédié, tel qu'un FPGA (« Field-Programmable Gate Array » en terminologie anglo-saxonne) ou un ASIC (« Application-Specific Integrated Circuit » en terùminologie anglo-saxonne).

La **Fig. 3** illustre schématiquement le procédé de relevé d'informations de compteurs électriques selon l'invention.

Le procédé décrit en relation avec la Fig. 3 est exécuté par le concentrateur de données 10, ou, plus précisément par le module de traitement 100 du concentrateur de données 10, périodiquement ou à la suite d'une requête émanant d'un utilisateur reçue par le concentrateur de données 10. Ce procédé est exécuté pendant une durée prédéfinie, dite durée de relevé, fixant un temps alloué au concentrateur de données 10 pour effectuer le relevé des compteurs du réseau CPL 1. Le concentrateur de données 10 tente donc de relever des informations d'un maximum de compteurs du réseau CPL 1 pendant la durée de relevé. Pour ce faire, le concentrateur de données 10 va utiliser notamment une connaissance d'une topologie du réseau CPL 1 pour diminuer les temps de contention.

Dans une étape 310, le module de traitement 100 obtient une information représentative de l'ensemble des compteurs du réseau CPL 1. Ces compteurs sont classés dans un nombre prédéterminé $N$ de classes. Dans un mode de réalisation, « $N=3$ ». Une première classe comprend des compteurs du réseau CPL 1 pour lesquels aucune information n'a été collectée au cours d'une exécution dudit procédé précédant une exécution courante. Une deuxième classe comprend des compteurs ayant un taux de réponse à des demandes d'informations transmises par ledit concentrateur de données 10 supérieur à un taux de référence prédéterminé. Une troisième classe comprend des compteurs ayant un taux de réponse aux demandes d'informations transmises par ledit concentrateur de données 10 inférieur ou égal audit taux de référence prédéterminé. L'information représentative de l'ensemble des compteurs du réseau CPL 1 obtenu lors de l'étape 310 indique pour chaque compteur, la classe à laquelle ce compteur appartient.

Dans un mode de réalisation, le taux de référence prédéterminé est de « 50 % ». Un compteur ayant un taux de réponse de « 50% » répond à une demande d'informations sur deux.

Dans une étape 311, le module de traitement 100 initialise une variable $n$ à zéro. La variable $n$ est utilisée pour parcourir les classes par ordre croissant, c'est-à-dire de la première à la troisième.

Dans une étape 312, le module de traitement 100 vérifie que la variable $n$ est inférieure au nombre de classes $N$ et vérifie que la durée écoulée depuis le début de la mise en œuvre du procédé de la Fig. 3 est inférieure à la durée de relevé. Si ces deux conditions sont remplies, le module de traitement 10 passe à des étapes 313 à 317. Sinon, le module de traitement 100 met fin au procédé de la Fig. 3.

Les étapes 313 à 317 sont exécutées itérativement pour chaque classe. A chaque itération, le module de traitement relève les informations des compteurs de la $n$-ième classe. Lors d'une première itération, le module de traitement 100 relève donc les informations des compteurs de la première classe. Puis, dans les itérations suivantes, le module de traitement 100 incrémente la variable $n$ d'une unité à chaque itération pour passer à la deuxième puis à la troisième classe. Le module de traitement 100 passe d'une classe en cours de relevé à une nouvelle classe lorsqu'il ne reste plus de compteurs à relever dans la classe en cours de relevé. En procédant ainsi, le module de traitement 100 privilégie les compteurs n'ayant pas été relevés lors de la dernière mise en œuvre du procédé de la Fig. 3, puis les compteurs ayant un bon taux de réponse et enfin les compteurs ayant un mauvais taux de réponse. De cette manière, les compteurs ayant un mauvais taux de réponse ne risquent pas de ralentir le relevé des informations des autres compteurs du réseau CPL 1. En effet, un compteur ayant un mauvais taux de réponse aux demandes d'informations émanant du concentrateur de données 10 est un compteur qui risque de ne pas répondre aux demandes d'informations qui lui sont transmises. Or, un compteur qui ne répond pas provoque des latences au niveau du concentrateur de données 10 puisque celui-ci doit attendre une expiration d'un temps d'attente maximum (« timeout » en terminologie anglo-saxonne) avant de pouvoir envoyer une demande d'informations à un autre compteur du réseau CPL 1. Un compteur ayant un bon taux de réponse répond immédiatement à une demande d'informations et de ce fait, le concentrateur de données n'a pas à attendre l'expiration du temps d'attente maximum pour pouvoir transmettre une demande d'informations à un autre compteur du réseau CPL 1. Ce traitement des compteurs par classe permet donc déjà d'accélérer le relevé d'informations par rapport à un traitement des compteurs aléatoire.

Dans chaque classe, chaque compteur électrique est classé dans au moins deux sous-classes. Chaque compteur est associé à une information représentative d'une topologie du réseau CPL 1 dans une zone où se situe le compteur influant sur un risque d'échec des transmissions d'informations par ledit compteur, dite information de risque. Dans un mode de réalisation, une première sous-classe comprend des compteurs associés à une information de risque inférieure à un premier seuil de risque prédéfini. Une deuxième sous-classe comprend des compteurs associés à une information de risque supérieure à un deuxième seuil de risque prédéfini. Une troisième sous-classe comprend des compteurs associés à une information de risque comprise entre le premier et le deuxième seuils de risque.

Dans l'étape 313, le module de traitement 100 obtient pour chaque compteur de la $n$-ième classe, une information représentative de la sous-classe à laquelle ce compteur appartient.

Dans une étape 314, le module de traitement 100 définit une liste de $M$ compteurs. La liste de compteurs comprend au moins un compteur de chaque sous-classe tant qu'il reste des compteurs à relever dans chaque sous-classe. De cette manière, le module de traitement 100 relève conjointement des compteurs ayant un risque d'échec important avec des compteurs ayant un risque d'échec moyen et des compteurs ayant un risque d'échec faible.

Dans l'étape 315, le module de traitement 100 envoie une demande d'informations à chaque compteur de la liste. Chaque demande d'informations est transmise en point à point sous forme d'une commande DLMS/COSEM (« Device Language Message Specification/ Companion Spécification for Energy Metering » en terminologie anglo-saxonne : IEC 62056).

Dans l'étape 316, le module de traitement 100 se met en attente des réponses de chaque compteur auquel il a envoyé une demande d'informations. Pour chaque compteur, à réception d'une réponse à la demande d'informations concernant ledit compteur ou à l'expiration d'un temps de réponse maximum prédéfini concernant ledit compteur lors d'une étape 3161, le module de traitement 100 remplace, lors d'une étape 3162, ledit compteur de la liste par un autre compteur de la même sous-classe tant qu'il reste des compteurs à relever dans ladite sous-classe. S'il n'y a plus de compteurs à relever dans la même sous-classe, le module de traitement 100 choisit un compteur dans une autre sous-classe dans laquelle il reste des compteurs à relever. Une demande d'informations est transmise à chaque compteur (étape 3163) par le module de traitement 100 suite à l'insertion dudit compteur dans ladite liste.

A chaque passage dans l'étape 3162, le module de traitement vérifie que la durée écoulée depuis le début de la mise en œuvre du procédé de la Fig. 3 est inférieure à la durée de relevé. Si la durée écoulée dépasse la durée de relevé, le module de traitement 100 met fin au procédé de la Fig. 3.

Lorsque tous les compteurs de la $n$-ième classe ont été relevés, le module de traitement 100 passe à l'étape 317 au cours de laquelle il incrémente la variable $n$ d'une unité pour passer à la classe suivante. Le module de traitement 100 revient ensuite à l'étape 312.

On note qu'à chaque réception d'une réponse ou à chaque expiration du temps d'attente maximum (timeout) pour un compteur, le module de traitement 100 met à jour le taux de réponse pour ce compteur.

On constate donc que tout au long de l'exécution du procédé de la Fig. 3, le module de traitement 100 fait en sorte de relever en parallèle des compteurs de chaque sous-classe. Ainsi, à un instant donné, des compteurs de sous-classes différentes répondent en parallèle à des demandes d'informations émanant du concentrateur de données 10. On réduit ainsi le risque que ces compteurs rentrent dans des périodes de contention car il y a peu de chance pour que des données de compteurs de la première sous-classe collisionnent des données de compteurs de la deuxième ou la troisième sous-classe. La situation aurait été différente si le module de traitement 100 avait relevé exclusivement des compteurs de la deuxième sous-classe à un instant donné. En effet, les compteurs de la deuxième sous-classe ont un fort risque de voir leur transmission de données échouer lorsqu'ils sont relevés simultanément, mais ce risque diminue sensiblement lorsqu'ils sont relevés avec des compteurs d'autres sous-classes.

Dans un mode de réalisation, l'information représentative d'une topologie du réseau CPL 1 dans une zone où se situe un compteur, dit premier compteur, influant sur un risque d'échec des transmissions d'informations par ledit premier compteur, comprend une valeur représentative d'une densité de compteurs au voisinage dudit premier compteur. En effet, plus un compteur est dans une zone dense en nombre de compteurs, *i.e.* plus il a de voisins dans le réseau CPL 1, plus ce compteur a de risque que des informations qu'il transmettrait vers le concentrateur de données 10 rentrent en collision avec des informations transmises par des compteurs de son voisinage si les compteurs de son voisinage sont relevés au même moment. Par contre, un compteur isolé aura moins de risques de voir les informations qu'il transmettrait rentrer en collision avec des informations d'autres compteurs. Dans ce mode de réalisation, par exemple, le premier seuil de risque est un nombre de voisins égal à cinq voisins et le deuxième seuil de risque est un nombre de voisins égal à quinze voisins. Ainsi, un compteur qui a un nombre de voisins supérieur ou égal au deuxième seuil de risque appartient à la deuxième sous-classe. C'est le cas par exemple des compteurs 200 à 206 de la Fig. 1. Un compteur qui a un nombre de voisins inférieur au premier seuil de risque appartient à la première sous-classe. C'est le cas par exemple des compteurs 400 et 401 de la Fig. 1. Les compteurs 300 à 302 de la Fig. 1 appartiennent à la troisième sous-classe.

On note que le concentrateur de données 10 peut obtenir à tout moment, pour chaque compteur, combien ce compteur comporte de voisins en utilisant une commande standard *GetRequest(POSTable)* du protocole DLMS / COSEM.

Dans ce mode de réalisation, les compteurs peuvent être classés dans chaque sous-classe par ordre décroissant du nombre de voisins. Dans ce cas, lors de la définition de la liste ou de la mise à jour de la liste, les compteurs de chaque sous-classe sont choisis dans leur ordre d'apparition dans ladite sous-classe.

Dans un mode de réalisation, l'information représentative d'une topologie du réseau CPL 1 dans une zone où se situe un compteur, dit premier compteur, influant sur un risque d'échec des transmissions d'informations par ledit premier compteur, comprend une valeur représentative d'un nombre de nœuds intermédiaires entre ledit premier compteur et ledit concentrateur de données 10. Chaque nœud intermédiaire est un compteur relayant des données du premier compteur vers le concentrateur de données 10. En effet, plus les données transmises par un compteur doivent passer par des nœuds intermédiaires, plus ces données ont de chances lors de leur retransmission par un nœud intermédiaire de rentrer en collision avec d'autres données provenant d'autres compteurs et ainsi d'induire des périodes de contention. Dans ce mode de réalisation, par exemple, le premier seuil de risque est un nombre de nœuds intermédiaires égal à trois et le deuxième seuil de risque est un nombre de nœuds intermédiaires égal à huit. Ainsi, un compteur dont les données doivent traverser un nombre de nœuds intermédiaires supérieur au deuxième seuil de risque pour atteindre le concentrateur de données 10 appartient à la deuxième sous-classe. Un compteur dont les données doivent traverser un nombre de nœuds intermédiaires inférieur au premier seuil de risque pour atteindre le concentrateur de données 10 appartient à la première sous-classe. Les autres compteurs de la classe appartiennent à la troisième sous-classe.

On note que le concentrateur de données 10 peut obtenir à tout moment, pour chaque compteur, le nombre de nœuds intermédiaires que les données dudit compteur doivent traverser pour atteindre le concentrateur de données 10 en lisant un attribut *hop_count* spécifié par le protocole G3-PLC dans une table de routage que le concentrateur de données 10 stocke pour ledit compteur.

Dans ce mode de réalisation, les compteurs peuvent être classés dans chaque sous-classe par ordre décroissant du nombre de nœuds intermédiaires que les données transmises par ces compteurs doivent traverser pour atteindre le concentrateur de données 10. Dans ce cas, lors de la définition de la liste ou du remplacement d'un compteur dans la liste, les compteurs de chaque sous-classe sont choisis dans leur ordre d'apparition dans ladite sous-classe.

Dans un mode de réalisation, l'information représentative d'une topologie du réseau dans une zone où se situe un compteur, dit premier compteur, influant sur un risque d'échec des transmissions d'informations par ledit premier compteur est une combinaison d'une valeur représentative d'un nombre de nœuds intermédiaires entre ledit premier compteur et ledit concentrateur de données 10 et d'une valeur représentative d'une densité de compteurs au voisinage dudit premier compteur. La combinaison est par exemple une combinaison linéaire ou une somme pondérée.

Dans un mode de réalisation, l'information représentative d'une topologie du réseau dans une zone où se situe un compteur, dit premier compteur, influant sur un risque d'échec des transmissions d'informations par ledit premier compteur est un vecteur à deux paramètres comprenant un premier paramètre correspondant à une valeur représentative d'un nombre de nœuds intermédiaires entre ledit premier compteur et ledit concentrateur de données 10 et un deuxième paramètre correspondant à une valeur représentative d'une densité de compteurs au voisinage dudit premier compteur. Chaque paramètre est alors associé à un premier seuil de risque (seuil de risque bas) et à un deuxième seuil de risque (seuil de risque haut) et chaque classe comprend alors neuf sous-classes.

Dans un mode de réalisation, le nombre de compteurs dans la liste « *NCL*=6 » et le module de traitement 100 choisit deux compteurs dans chaque sous-classe.

Dans un mode de réalisation, la liste comprend un nombre de compteurs pour chaque sous-classe proportionnelle à un nombre de compteurs de la classe appartenant à ladite sous-classe. Ainsi, plus une sous-classe d'une classe compte de compteurs, plus cette sous-classe est représentée dans la liste.

Dans un mode de réalisation, le premier et le deuxième seuils de risque sont définis de manière à avoir autant de compteurs dans chaque sous-classe. Dans ce cas, lors de la définition de la première liste, le module de traitement 100 choisit le même nombre de compteurs dans chaque sous-classe.

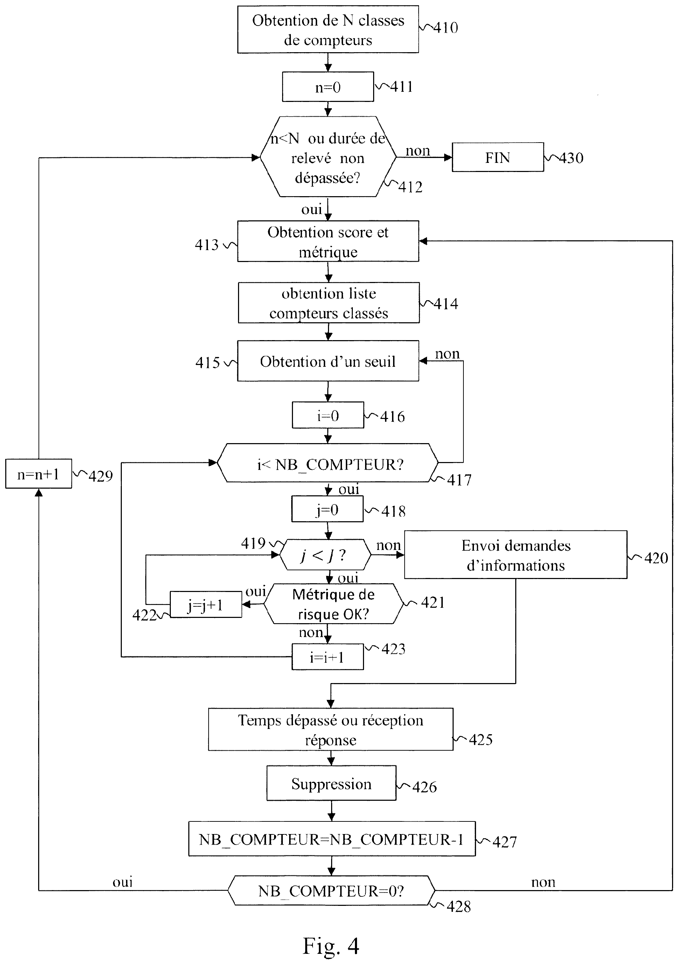

La **Fig. 4** illustre schématiquement un deuxième exemple de procédé de relevé d'informations de compteurs électriques selon l'invention.

Le procédé décrit en relation avec la Fig. 4 est lui aussi exécuté par le module de traitement 100 du concentrateur de données 10, périodiquement ou à la suite d'une requête émanant d'un utilisateur reçue par le concentrateur de données 10. Comme dans le cas du procédé décrit en relation avec la Fig. 3, le procédé de la Fig. 4 est exécuté pendant une durée de relevé. Là encore le concentrateur de données 10 va utiliser ses connaissances de la topologie du réseau CPL 1 pour diminuer les temps de contention.

Dans une étape 410, le module de traitement 100 obtient une information représentative de l'ensemble des compteurs du réseau CPL 1. Ces compteurs sont classés lors de l'étape 410 en *N* classes de la même manière que dans l'étape 310. L'information représentative de l'ensemble des compteurs du réseau CPL 1 obtenu lors de l'étape 310 indique donc pour chaque compteur, la classe à laquelle ce compteur appartient.

Dans une étape 411, le module de traitement 100 initialise une variable *n* à zéro. La variable *n* est utilisée pour parcourir les classes par ordre croissant, c'est-à-dire de la première à la troisième.

Dans une étape 412, le module de traitement 100 vérifie que la variable *n* est inférieure au nombre de classes *N* et vérifie que la durée écoulée depuis le début de la mise en œuvre du procédé de la Fig. 4 est inférieure à la durée de relevé. Si l'une de ces conditions n'est pas remplie, le module de traitement 100 met fin au procédé de la Fig. 4 lors de l'étape 430. Sinon, le module de traitement passe à une étape 413.

Lors des étapes 413 à 429, le module de traitement 100 procède au traitement d'une classe, dite classe courante.

Lors de l'étape 413, le module de traitement 100 calcule pour chaque paire de compteurs de la classe courante, une valeur, dite métrique de risque, proportionnelle à un risque qu'une transmission d'informations émanant d'un compteur de la paire rentre en collision avec une transmission simultanée d'informations émanant de l'autre compteur de la paire. Dans un mode de réalisation, la métrique de risque *M* d'une paire de compteurs est fonction d'un nombre *N* de nœuds communs entre les deux compteurs de la paire sur un chemin utilisé par chaque compteur pour communiquer avec le concentrateur de données 10 et d'une position relative *P* de chaque nœud commun dans ledit chemin.

$$M = \sum_{i=1}^{i=N} C \times w^P$$

où le paramètre C est un coût prédéfini, dit coût de contention, attribué à une paire de compteurs lorsque pour chaque compteur de la paire, le chemin menant au concentrateur de données 10 possède un nœud en commun situé à égale distance des deux compteurs de la paire, la distance étant calculée en nombre de nœuds. Le paramètre *C* est positif et par exemple obtenu expérimentalement. Le paramètre *w* est une pondération prédéfinie qui vient atténuer l'impact du coût prédéfini dans le calcul de la métrique de risque lorsque le nœud en commun sur le chemin utilisé par chaque compteur pour communiquer avec le concentrateur de données 10 est décalé de *P* nœuds. Le paramètre w est une valeur positive comprise dans [0 ;1[.

La valeur de risque d'une paire de compteurs est donc proportionnelle à un risque qu'une transmission d'informations émanant d'un compteur de la paire rentre en collision avec une transmission simultanée d'informations émanant de l'autre compteur de la paire.

Dans un mode de réalisation $C$=0.75 et $w$=0.5.

TAB 1

| Chemin 200 | Chemin 201 | Chemin 204 | Chemin 302 |
|---|---|---|---|
| 206 | 206 | 203 | 300 |
| 10 | 10 | 206 | 10 |
|  |  | 10 |  |

En reprenant l'exemple de la Fig. 1, le tableau TAB 1 représente le chemin utilisé par le compteur 200 dans la première colonne à gauche (respectivement le compteur 201 dans la deuxième colonne, le compteur 204 dans la troisième colonne et le compteur 302 dans la quatrième colonne) pour atteindre le concentrateur de données 10.

Tous les chemins ont au moins le nœud représentant le concentrateur de données 10 en commun.

La paire constituée des compteurs 200 et 201 a deux nœuds en commun situés à égales positions sur les deux chemins (donc $P$=0). Dans ce cas, la métrique de risque pour cette paire est calculée de la manière suivante :

$$M_{200}^{201} = \sum_{i=1}^{i=N} C \times w^P = 0.75 \times 0.5^0 + 0.75 \times 0.5^0 = 1.5$$

La paire constituée des compteurs 200 et 204 a deux nœuds en commun décalés d'un nœud (donc $P$=1). Dans ce cas, la métrique de risque pour cette paire est calculée de la manière suivante :

$$M_{200}^{204} = \sum_{i=1}^{i=N} C \times w^P = 0.75 \times 0.5^1 + 0.75 \times 0.5^1 = 0.75$$

La paire constituée des compteurs 200 et 302 a un nœud en commun situé à égale position sur les deux chemins (donc $P$=0). Dans ce cas, la métrique de risque pour cette paire est calculée de la manière suivante :

$$M_{200}^{302} = \sum_{i=1}^{i=N} C \times w^P = 0.75 \times 0.5^0 = 0.75$$

Lors de l'étape 413, le module de traitement 100 calcule pour chaque compteur de la classe courante une valeur, dite score de risque, représentative d'une topologie du réseau influant sur un risque d'échec des transmissions d'informations par ledit compteur. Plus le score de risque est élevé, plus le risque d'échec des transmissions d'informations par ledit compteur est élevé.

Le score de risque $S_c$ d'un compteur c est une moyenne de la métrique de risque calculée pour chaque paire de compteurs dans laquelle est impliqué ledit compteur.

$$S_c = \frac{\sum_{k=1}^{k=K-1} M_c^k}{K - 1}$$

où $K$ est le nombre de compteurs dans la classe.

En prenant l'exemple du compteur 200 de la Fig. 1 :

$$S_{200} = (M_{200}^{201} + M_{200}^{202} + M_{200}^{203} + M_{200}^{204} + M_{200}^{205} + M_{200}^{206} + M_{200}^{300} + M_{200}^{301} + M_{200}^{302} + M_{200}^{400} + M_{200}^{401})/11$$

Dans une étape 414, le module de traitement 100 classe les compteurs de la classe courante par ordre décroissant de scores de risque. Les compteurs ayant le plus de risques de créer une contention en cas de transmission d'informations en direction du concentrateur de données 10 apparaissent donc en premier dans le classement obtenu.

Dans une étape 415, le module de traitement 100 affecte une valeur d'initialisation à un seuil *Th,* dit seuil de risque. Le seuil de risque *Th* est utilisé par la suite pour déterminer si deux compteurs peuvent être interrogés simultanément par le concentrateur de données 10.

Dans un mode de réalisation, la valeur d'initialisation est obtenue expérimentalement.

Dans un mode de réalisation, la valeur d'initialisation est une moyenne ou une valeur médiane des valeurs de scores de risque de tous les compteurs de la classe.

Nous verrons par la suite que le seuil de risque *Th* peut être mis à jour par le module de traitement 100 sous certaines conditions.

Dans une étape 416, le module de traitement 100 initialise une variable *i* à « 0 ». La variable *i* permet de parcourir les compteurs de la classe courante dans l'ordre des scores de risque décroissant, c'est-à-dire dans l'ordre selon lequel les compteurs ont été classés.

L'étape 416 est suivie d'étapes 417 à 424 permettant de définir une liste d'un nombre prédéfini *J* de compteurs en extrayant les compteurs de la classe par ordre décroissant des valeurs du score de risque. La liste est formée sous contrainte puisqu'elle doit respecter une condition prédéterminée telle que à chaque paire possible de compteurs de la liste est associée une métrique de risque inférieure au seuil de risque.

Dans l'étape 417, le module de traitement 100 vérifie si tous les compteurs de la classe ont été interrogés en comparant la valeur courante de la variable *i* avec un nombre courant de compteurs dans la classe courante *NB_COMPTEUR.*

S'il reste des compteurs à interroger dans la classe courante, le module de traitement 100 met en œuvre une étape 418 au cours de laquelle il initialise une variable *j* à « 0 ». *j* permet de compter le nombre de compteurs déjà présents dans la liste.

Dans une étape 419, le module de traitement 100 vérifie si la variable *j* est inférieure au nombre prédéfini de compteurs *J*. Si c'est le cas, le module de traitement 100 passe à une étape 421.

Lors de l'étape 421, le module de traitement 100 vérifie si la valeur de la métrique de risque du compteur *i* de la liste avec chaque compteur déjà présent dans la liste est inférieure au seuil de risque *Th.* Si le compteur *i* est le premier de la liste, il est directement inséré dans la liste. Si le compteur *i* n'est pas le premier dans la liste, si pour chaque paire de compteurs formée du compteur *i* et d'un compteur déjà présent dans la liste, la métrique de risque est inférieure au seuil de risque *Th,* le compteur *i* est inséré dans la liste. Dans ces deux derniers cas, l'étape 421 est suivie d'une étape 422 au cours de laquelle la variable *j* est incrémentée d'une unité.

Si lors de l'étape 421 il apparaît qu'au moins une des métriques de risque considérées est supérieure à *J*, le module de traitement 100 incrémente la variable *i* d'une unité lors d'une étape 423 pour passer au compteur suivant de la classe courante et ainsi essayer de former une liste de *J* compteurs avec ce nouveau compteur.

L'étape 423 est suivie de l'étape 417 déjà expliquée.

Si lors de l'étape 417, la variable *i* est égale au nombre de compteurs dans la classe *NB_COMPTEUR,* cela signifie qu'avec la valeur du seuil de risque courante *Th,* il a été impossible d'insérer tous les compteurs de la classe courante dans une liste de *J* compteurs. La valeur du seuil de risque *Th* est alors considérée comme trop contraignante. Certains compteurs de la classe courante n'ont donc pas été interrogés. Dans ce cas, le module de traitement 100 retourne à l'étape 415 au cours de laquelle la valeur du seuil de risque *Th* est augmentée.

Dans un mode de réalisation, la valeur de seuil de risque *Th* est augmentée de « 10% » par rapport à la valeur de seuil de risque *Th* précédente lors de l'étape 415 :

$$Th = Th\,(1 + 0.1)$$

Ensuite, les étapes 416 à 423 sont remises en œuvre sur les compteurs restant à interroger dans la classe courante.

Si, lors de l'étape 419, *j=J, i.e.* une liste de *J* compteurs a été formée, le module de traitement 100 envoi une demande d'informations à chaque compteur de la liste n'ayant pas encore été interrogé lors d'une étape 420.

Suite à l'envoi d'une demande d'informations, le module de traitement 100 se met en attente de réception d'une réponse à cette demande.

A chaque réception d'une réponse à une demande d'informations transmise à un compteur de la liste ou à chaque expiration d'un temps de réponse maximum prédéfini (timeout) concernant un compteur de la liste, le module de traitement 100 met fin à cette attente lors d'une étape 425.

Dans une étape 426, le module de traitement 100 supprime le compteur concerné par la réponse reçue ou par l'expiration du temps de réponse maximum prédéfini de la classe.

Dans une étape 427, le module de traitement 100 prend en compte la suppression d'un compteur de la classe en réduisant le nombre de compteurs de la classe courante *NB_COMPTEUR* d'une unité.

Si, après réduction, le nombre de compteurs dans la classe courante *NB_COMPTEUR* n'est pas nul, le module de traitement 100 retourne à l'étape 413, pour traiter la classe courante après sa mise à jour lors de l'étape 426.

Si, après réduction, le nombre de compteurs dans la classe courante *NB_COMPTEUR* est nul, le module de traitement 100 considère que tous les compteurs de la classe courante ont été interrogés et qu'il peut passer à la classe suivante. Pour ce faire, lors d'une étape 429 le module de traitement 100 incrémente la variable n d'une unité et retourne à l'étape 412.

Dans un mode de réalisation, le module de traitement 100 pourrait retourner à l'étape 412 suite à l'étape 428 de manière à vérifier que la durée de relevé n'est pas dépassée plus fréquemment.

## Revendications

**1.** Procédé de relevé d'informations d'un ensemble de compteurs électriques, dit compteurs, reliés par un réseau d'alimentation électrique (1) à un concentrateur de données (10), dit concentrateur, avec lequel lesdits compteurs communiquent par courant porteur en ligne, **caractérisé en ce que** le procédé est exécuté par ledit concentrateur et comprend :

obtenir (410) une information représentative d'un ensemble de compteurs classés dans une pluralité de classes, une première classe comprenant des compteurs pour lesquels aucune information n'a été collectée au cours d'une exécution dudit procédé précédant une exécution courante, et une pluralité de secondes classes regroupant des compteurs en fonction d'un taux de réponse à des demandes d'informations transmises par ledit concentrateur, les secondes classes étant ordonnées par ordre de taux de réponse décroissant ;
pendant une durée prédéfinie fixant un temps alloué au concentrateur pour effectuer le relevé des compteurs dudit ensemble, parcourir (412) chaque classe une à une par ordre croissant de classes en passant d'une classe en cours de relevé à une nouvelle classe lorsqu'il ne reste plus de compteurs à relever dans la classe en cours de relevé ; et, dans chaque classe :

définir (417 ; 423) une liste d'un nombre prédéfini de compteurs de la classe, chaque compteur de la liste étant associé à une information représentative d'une topologie du réseau dans une zone comprenant ledit compteur influant sur un risque d'échec des transmissions d'informations par ledit compteur, dite information de risque, ladite liste respectant une condition prédéterminée telle qu'au moins un des compteurs de la liste est associé à une information de risque inférieure à un seuil prédéterminé, une demande d'informations (420) étant transmise à chaque compteur suite à son insertion dans ladite liste ; et,
pour chaque compteur de la liste, à réception (425) d'une réponse à une demande d'informations concernant ledit compteur ou à l'expiration d'un temps de réponse maximum prédéfini concernant ledit compteur, mettre à jour (426) la liste en remplaçant ledit compteur de la liste par un autre compteur de la classe de sorte que la liste mise à jour respecte la condition prédéterminée.

**2.** Procédé selon la revendication 1, **caractérisé en ce que** la pluralité de secondes classes comprend une deuxième classe comprenant des compteurs ayant un taux de réponse à des demandes d'informations transmises par ledit concentrateur supérieur à un taux de référence prédéterminé et une troisième classe comprenant des compteurs ayant un taux de réponse aux demandes d'informations transmises par ledit concentrateur inférieur ou égal audit taux de référence prédéterminé.

**3.** Procédé selon la revendication 2, **caractérisé en ce que** l'information de risque est un score de risque, et lors du parcours d'une classe, chaque liste est formée en extrayant les compteurs de la classe par ordre décroissant des valeurs de score de risque et de manière à respecter une condition prédéterminée sur la liste telle que à chaque paire possible de compteurs de la liste est associé une métrique de risque inférieure à un seuil prédéterminé, ladite métrique étant proportionnelle à un risque qu'une transmission d'information émanant d'un compteur de la paire rentre en collision avec une transmission simultanée d'informations émanant de l'autre compteur de la paire.

**4.** Procédé selon la revendication 3, **caractérisé en ce que** la métrique de risque d'une paire de compteurs est fonction d'un nombre de nœuds communs entre les deux compteurs de la paire sur un chemin utilisé par chaque compteur de la paire pour communiquer avec le concentrateur et d'une position relative de chaque nœud commun dans ledit chemin.

**5.** Procédé selon la revendication 4, **caractérisé en ce que** pour chaque compteur de la classe, le score de risque dudit compteur est une moyenne de la métrique de risque calculée pour chaque paire de compteur dans laquelle est impliqué ledit compteur.

**6.** Procédé selon la revendication 5, **caractérisé en ce que** la valeur de seuil prédéterminée est une moyenne des scores de risque.

**7.** Procédé selon l'une quelconque des revendications 3 à 6, à chaque mise à jour de la liste, le compteur concerné par la réponse à la demande d'informations ou par l'expiration d'un temps de réponse maximum prédéfini est supprimé de la classe (426) et les scores de risques sont recalculés (413) pour les compteurs restants de la classe en prenant en compte la suppression dudit compteur concerné de la classe.

**8.** Procédé selon la revendication 2, **caractérisé en ce que**, dans chaque classe, les compteurs sont en outre classés dans au moins deux sous-classes, une première sous-classe comprenant des compteurs associés à une information de risque inférieure à un premier seuil de risque prédéterminé et une deuxième sous-classe comprenant des compteurs associés à une information de risque supérieure à un deuxième seuil de risque prédéterminé, la liste comprenant au moins un compteur de chaque sous-classe tant que chaque sous-classe comprend au moins un compteur à relever et **en ce que**, lors de la mise à jour, la liste étant mise à jour en remplaçant un compteur de la liste par un autre compteur de la même sous-classe tant qu'il reste des compteurs à relever dans ladite sous-classe.

**9.** Procédé selon la revendication 8, **caractérisé en ce que** l'information de risque associée à un compteur, dit premier compteur, comprend une valeur représentative d'une densité de compteurs au voisinage dudit premier compteur et/ou une valeur représentative d'un nombre de nœuds intermédiaires entre ledit premier compteur et ledit concentrateur, chaque nœud intermédiaire étant un compteur relayant des trames du premier compteur vers le concentrateur.

**10.** Procédé selon la revendication 8 ou 9, **caractérisé en ce que** la liste comprend un nombre de compteurs pour chaque sous-classe proportionnelle à un nombre de compteurs de la classe appartenant à ladite sous-classe.

**11.** Procédé selon la revendication 8 ou 9, **caractérisé en ce que** le premier et le deuxième seuils de risque sont définis de manière à avoir autant de compteurs dans chaque sous-classe et la liste comprend un même nombre de compteurs de chaque sous-classe.

**12.** Procédé selon l'une quelconque des revendications 9 à 11, **caractérisé en ce que**, les compteurs sont ordonnés dans chaque sous-classe par ordre de valeurs représentatives d'une densité de compteurs décroissante et/ou par ordre de valeurs représentatives d'un nombre de nœuds intermédiaires décroissantes, et lors de la définition de la liste ou de chaque mise à jour de la liste, les compteurs d'une sous-classe sont pris dans leur ordre d'apparition dans ladite sous-classe.

**13.** Dispositif configuré pour mettre en œuvre un procédé de relevé d'informations d'un ensemble de compteurs électriques, dit compteurs, reliés par un réseau d'alimentation électrique (1) à un concentrateur de données (10), dit concentrateur, avec lequel lesdits compteurs communiquent par courant porteur en ligne, **caractérisé en ce que** le dispositif comprend :

des moyens d'obtention pour obtenir (410) une information représentative d'un ensemble de compteurs classés dans une pluralité de classes, une première classe comprenant des compteurs pour lesquels aucune information n'a été collectée au cours d'une exécution dudit procédé précédant une exécution courante, et une pluralité de secondes classes regroupant des compteurs en fonction d'un taux de réponse à des demandes d'informations transmises par ledit concentrateur, les secondes classes étant ordonnées par ordre de taux de réponse décroissant ;
des moyens de parcours pour parcourir (412), pendant une durée prédéfinie fixant un temps alloué pour effectuer le relevé des compteurs dudit ensemble, chaque classe une à une par ordre croissant de classes en passant d'une classe en cours de relevé à une nouvelle classe lorsqu'il ne reste plus de compteurs à relever dans la classe en cours de relevé ; et, des moyens exécutés pour chaque classe comprenant :

des moyens de définition pour définir (417 ; 423) une liste d'un nombre prédéfini de compteurs de la classe, chaque compteur de la liste étant associé à une information représentative d'une topologie du réseau dans une zone comprenant ledit compteur influant sur un risque d'échec des transmissions d'informations par ledit compteur, dite information de risque, ladite liste respectant une condition prédéterminée telle qu'au moins un des compteurs de la liste est associé à une information de risque inférieure à un seuil prédéterminé ; des moyens de transmission pour transmettre une demande d'informations à chaque compteur suite à son insertion dans ladite liste ; et,

des moyens de mise à jour de liste, exécutés pour chaque compteur de la liste, à réception (425) d'une réponse à une demande d'informations concernant ledit compteur ou à l'expiration d'un temps de réponse maximum prédéfini concernant ledit compteur, la liste étant mise à jour (426) en remplaçant ledit compteur de la liste par un autre compteur de la classe de sorte que la liste mise à jour respecte la condition prédéterminée.

14. Dispositif selon la revendication 13, **caractérisé en ce que** la pluralité de secondes classes comprend une deuxième classe comprenant des compteurs ayant un taux de réponse à des demandes d'informations transmises par ledit concentrateur supérieur à un taux de référence prédéterminé et une troisième classe comprenant des compteurs ayant un taux de réponse aux demandes d'informations transmises par ledit concentrateur inférieur ou égal audit taux de référence prédéterminé.

15. Programme d'ordinateur, **caractérisé en ce qu'**il comprend des instructions pour mettre en œuvre, par un dispositif, le procédé selon l'une quelconque des revendications 1 à 12 lorsque ledit programme est exécuté par un processeur dudit dispositif.

16. Moyens de stockage, **caractérisés en ce qu'**ils stockent un programme d'ordinateur comprenant des instructions pour mettre en œuvre, par un dispositif, le procédé selon l'une quelconque des revendications 1 à 12 lorsque ledit programme est exécuté par un processeur dudit dispositif.

**Patentansprüche**

1. Verfahren zur Erfassung von Informationen eines Satzes von Stromzählern, Zähler genannt, die über ein Stromversorgungsnetz (1) mit einem Datenkonzentrator (10), Konzentrator genannt, verbunden sind, mit dem die Zähler mittels Powerline Communication kommunizieren, **dadurch gekennzeichnet, dass** das Verfahren von dem Konzentrator ausgeführt wird und umfasst:

Gewinnen (410) einer Information, die für einen Satz von Zählern repräsentativ ist, die in mehrere Klassen eingeteilt sind, wobei eine erste Klasse Zähler umfasst, für welche während einer Ausführung des Verfahrens, die einer aktuellen Ausführung vorangegangen ist, keine Informationen gesammelt wurden, und wobei mehrere zweite Klassen Zähler in Abhängigkeit von einer Antwortrate für von dem Konzentrator übertragene Informationsanforderungen umfassen, wobei die zweiten Klassen in der Reihenfolge abnehmender Antwortrate geordnet sind;

während einer vordefinierten Dauer, die eine dem Konzentrator zugewiesene Zeit zum Durchführen des Ablesens der Zähler des Satzes festlegt, Durchlaufen (412) der einzelnen Klassen nacheinander in wachsender Reihenfolge der Klassen, wobei von einer Klasse, die gerade abgelesen wird, zu einer neuen Klasse übergegangen wird, wenn in der gerade abgelesenen Klasse keine abzulesenden Zähler mehr verbleiben; und, in jeder Klasse:

Definieren (417; 423) einer Liste einer vordefinierten Anzahl von Zählern der Klasse, wobei jeder Zähler der Liste einer Information zugeordnet ist, die für eine Topologie des Netzes in einem den Zähler umfassenden Bereich repräsentativ ist, die ein Risiko des Fehlschlagens der Übertragungen von Informationen durch den Zähler beeinflusst, Risikoinformation genannt, wobei die Liste eine solche vorbestimmte Bedingung erfüllt, dass wenigstens einer der Zähler der Liste einer Risikoinformation zugeordnet ist, die niedriger als ein vorbestimmter Schwellenwert ist, wobei eine Informationsanforderung (420) an jeden Zähler im Anschluss an seine Einfügung in die Liste übertragen wird; und

für jeden Zähler der Liste, bei Empfang (425) einer Antwort auf eine diesen Zähler betreffende Informationsanforderung oder bei Ablauf einer diesen Zähler betreffenden vordefinierten maximalen Antwortzeit, Aktualisieren (426) der Liste durch Ersetzen dieses Zählers der Liste durch einen anderen Zähler der Klasse, so dass die aktualisierte Liste die vorbestimmte Bedingung erfüllt.

2. Verfahren nach Anspruch 1, **dadurch gekennzeichnet, dass** die mehreren zweiten Klassen eine zweite Klasse umfassen, die Zähler umfasst, die eine Antwortrate für von dem Konzentrator übertragene Informationsanforderungen aufweisen, die größer als eine vorbestimmte Referenzrate ist, und eine dritte Klasse, die Zähler umfasst, die eine Antwortrate für die von dem Konzentrator übertragenen Informationsanforderungen aufweisen, die kleiner oder gleich der vorbestimmten Referenzrate ist.

3. Verfahren nach Anspruch 2, **dadurch gekennzeichnet, dass** die Risikoinformation ein Risiko-Score ist und beim Durchlaufen einer Klasse jede Liste gebildet wird, indem die Zähler der Klasse in abnehmender Reihenfolge der Werte des Risiko-Scores extrahiert werden, und derart, dass eine solche vorbestimmte Bedingung auf der Linse eingehalten wird, dass jedem möglichen Paar von Zählern der Liste eine Risikometrik zugeordnet ist, die kleiner als ein vorbestimmter Schwellenwert ist, wobei die Metrik proportional zu einem Risiko ist, dass eine von einem Zähler des Paares ausgehende Übertragung von Informationen mit einer gleichzeitigen Übertragung von Informationen kollidiert, die von dem anderen Zähler des Paares ausgeht.

4. Verfahren nach Anspruch 3, **dadurch gekennzeichnet, dass** die Risikometrik eines Paares von Zählern von einer Anzahl von Knoten, die den zwei Zählern des Paares auf dem jeweiligen Weg, der von den Zählern des Paares verwendet wird, um mit dem Konzentrator zu kommunizieren, gemeinsam sind, und von einer relativen Position jedes gemeinsamen Knotens auf diesem Weg abhängig ist.

5. Verfahren nach Anspruch 4, **dadurch gekennzeichnet, dass** für jeden Zähler der Klasse der Risiko-Score des Zählers ein Mittelwert der Risikometrik ist, die für jedes Zählerpaar, dem der Zähler angehört, berechnet wurde.

6. Verfahren nach Anspruch 5, **dadurch gekennzeichnet, dass** der vorbestimmte Schwellenwert ein Mittelwert der Risiko-Scores ist.

7. Verfahren nach einem der Ansprüche 3 bis 6, wobei bei jeder Aktualisierung der Liste der von der Antwort auf die Anforderung von Informationen oder vom Ablauf einer vordefinierten maximalen Antwortzeit betroffene Zähler aus der Klasse entfernt wird (426) und die Risiko-Scores für die verbleibenden Zähler der Klasse unter Berücksichtigung der Entfernung des betroffenen Zählers der Klasse neu berechnet werden (413).

8. Verfahren nach Anspruch 2, **dadurch gekennzeichnet, dass** in jeder Klasse die Zähler außerdem in wenigstens zwei Unterklassen eingeteilt sind, wobei eine erste Unterklasse Zähler umfasst, die einer Risikoinformation zugeordnet sind, die kleiner als ein vorbestimmter erster Risikoschwellenwert ist, und eine zweite Unterklasse Zähler umfasst, die einer Risikoinformation zugeordnet sind, die größer als ein vorbestimmter zweiter Risikoschwellenwert ist, wobei die Liste wenigstens einen Zähler jeder Unterklasse umfasst, solange jede Unterklasse wenigstens einen abzulesenden Zähler umfasst, und dadurch, dass bei der Aktualisierung die Liste aktualisiert wird, indem ein Zähler der Liste durch einen anderen Zähler derselben Unterklasse ersetzt wird, solange abzulesende Zähler in dieser Unterklasse verbleiben.

9. Verfahren nach Anspruch 8, **dadurch gekennzeichnet, dass** die Risikoinformation, die einem Zähler, erster Zähler genannt, zugeordnet ist, einen Wert umfasst, der für eine Dichte von Zählern in der Umgebung des ersten Zählers repräsentativ ist, und/oder einen Wert, der für eine Anzahl von Zwischenknoten zwischen dem ersten Zähler und dem Konzentrator repräsentativ ist, wobei jeder Zwischenknoten ein Zähler ist, der Rahmen des ersten Zählers in Richtung des Konzentrators weiterleitet.

10. Verfahren nach Anspruch 8 oder 9, **dadurch gekennzeichnet, dass** die Liste eine Anzahl von Zählern für jede Unterklasse umfasst, die proportional zu einer Anzahl von Zählern der Klasse ist, die dieser Unterklasse angehören.

11. Verfahren nach Anspruch 8 oder 9, **dadurch gekennzeichnet, dass** der erste und der zweite Risikoschwellenwert so definiert sind, dass gleich viele Zähler in jeder Unterklasse vorhanden sind und die Liste ein und dieselbe Anzahl von Zählern jeder Unterklasse umfasst.

12. Verfahren nach einem der Ansprüche 9 bis 11, **dadurch gekennzeichnet, dass** die Zähler in jeder Unterklasse in einer Reihenfolge von Werten geordnet sind, die für eine abnehmende Dichte von Zählern repräsentativ sind, und/oder in einer Reihenfolge abnehmender Werte, die für eine Anzahl von Zwischenknoten repräsentativ sind, und bei der Definition der Liste oder jeder Aktualisierung der Liste die Zähler einer Unterklasse in ihrer Reihenfolge des Erscheinens in der Unterklasse genommen werden.

**13.** Vorrichtung, welche dafür ausgelegt ist, ein Verfahren zur Erfassung von Informationen eines Satzes von Stromzählern, Zähler genannt, durchzuführen, die über ein Stromversorgungsnetz (1) mit einem Datenkonzentrator (10), Konzentrator genannt, verbunden sind, mit dem die Zähler mittels Powerline Communication kommunizieren, **dadurch gekennzeichnet, dass** die Vorrichtung umfasst:

Gewinnungsmittel zum Gewinnen (410) einer Information, die für einen Satz von Zählern repräsentativ ist, die in mehrere Klassen eingeteilt sind, wobei eine erste Klasse Zähler umfasst, für welche während einer Ausführung des Verfahrens, die einer aktuellen Ausführung vorangegangen ist, keine Informationen gesammelt wurden, und wobei mehrere zweite Klassen Zähler in Abhängigkeit von einer Antwortrate für von dem Konzentrator übertragene Informationsanforderungen umfassen, wobei die zweiten Klassen in der Reihenfolge abnehmender Antwortrate geordnet sind;

Durchlaufmittel zum Durchlaufen (412), während einer vordefinierten Dauer, die eine zugewiesene Zeit zum Durchführen des Ablesens der Zähler des Satzes festlegt, der einzelnen Klassen nacheinander in wachsender Reihenfolge der Klassen, wobei von einer Klasse, die gerade abgelesen wird, zu einer neuen Klasse übergegangen wird, wenn in der gerade abgelesenen Klasse keine abzulesenden Zähler mehr verbleiben; und für jede Klasse ausgeführte Mittel, die umfassen:

Definitionsmittel zum Definieren (417; 423) einer Liste einer vordefinierten Anzahl von Zählern der Klasse, wobei jeder Zähler der Liste einer Information zugeordnet ist, die für eine Topologie des Netzes in einem den Zähler umfassenden Bereich repräsentativ ist, die ein Risiko des Fehlschlagens der Übertragungen von Informationen durch den Zähler beeinflusst, Risikoinformation genannt, wobei die Liste eine solche vorbestimmte Bedingung erfüllt, dass wenigstens einer der Zähler der Liste einer Risikoinformation zugeordnet ist, die niedriger als ein vorbestimmter Schwellenwert ist;

Übertragungsmittel zum Übertragen einer Informationsanforderung an jeden Zähler im Anschluss an seine Einfügung in die Liste; und Listenaktualisierungsmittel, die für jeden Zähler der Liste bei Empfang (425) einer Antwort auf eine diesen Zähler betreffende Informationsanforderung oder bei Ablauf einer diesen Zähler betreffenden vordefinierten maximalen Antwortzeit ausgeführt werden, wobei die Liste aktualisiert wird (426), indem der Zähler der Liste durch einen anderen Zähler der Klasse ersetzt wird, so dass die aktualisierte Liste die vorbestimmte Bedingung erfüllt.

**14.** Vorrichtung nach Anspruch 13, **dadurch gekennzeichnet, dass** die mehreren zweiten Klassen eine zweite Klasse umfassen, die Zähler umfasst, die eine Antwortrate für von dem Konzentrator übertragene Informationsanforderungen aufweisen, die größer als eine vorbestimmte Referenzrate ist, und eine dritte Klasse, die Zähler umfasst, die eine Antwortrate für die von dem Konzentrator übertragenen Informationsanforderungen aufweisen, die kleiner oder gleich der vorbestimmten Referenzrate ist.

**15.** Computerprogramm, **dadurch gekennzeichnet, dass** es Anweisungen zur Durchführung, durch eine Vorrichtung, des Verfahrens nach einem der Ansprüche 1 bis 12, wenn das Programm von einem Prozessor der Vorrichtung ausgeführt wird, umfasst.

**16.** Speichermittel, **dadurch gekennzeichnet, dass** sie ein Computerprogramm speichern, das Anweisungen zur Durchführung, durch eine Vorrichtung, des Verfahrens nach einem der Ansprüche 1 bis 12, wenn das Programm von einem Prozessor der Vorrichtung ausgeführt wird, umfasst.

**Claims**

**1.** Method for reading information from a set of electricity meters, referred to as meters, connected by an electricity supply network (1) to a data concentrator (10), referred to as a concentrator, with which said meters communicate by powerline, **characterised in that** the method is executed by said concentrator and comprises:

obtaining (410) information representing a set of meters classified in a plurality of classes, a first class comprising meters for which no information has been collected during the execution of said method preceding a current execution, and a plurality of second classes containing meters according to a rate of response to requests for information transmitted by said concentrator, the second classes being ordered by decreasing order of response rate;
during a predefined period fixing a time allocated to the concentrator for carrying out the reading of the meters in said set, running through (412) each class one by one by increasing order of classes, passing from a class currently being read to a new class when there no longer remain any meters to be read in the class currently being read; and, in each class:

defining (417; 423) a list of a predefined number of meters in the class, each meter in the list being associated with information representing a topology of the network in a zone comprising said meter having an influence on a risk of failure of the transmissions of information by said meter, referred to as risk information, said list satisfying a predetermined condition such that at least one of the meters in the list is associated with risk information below a predetermined threshold, a request for information (420) being transmitted to each meter following insertion thereof in said list; and,

for each meter in the list, on reception (425) of a response to a request for information concerning said meter or at the expiry of a predefined maximum response time concerning said meter, updating (426) the list by replacing said meter in the list with another meter in the class so that the updated list satisfies the predetermined condition.

2. Method according to claim 1, **characterised in that** the plurality of second classes comprises a second class comprising meters having a rate of response to requests for information transmitted by said concentrator higher than a predetermined reference level and a third class comprising meters having a rate of response to the requests for information transmitted by said concentrator below or equal to said predetermined reference rate.

3. Method according to claim 2, **characterised in that** the risk information is a risk score and, when running through a class, each list is formed by extracting the meters from the class in decreasing order of the risk scores and so as to satisfy a predetermined condition on the list such that a risk metric below a predetermined threshold is associated with each possible pair of meters in the list, said metric being proportional to a risk that a transmission of information emanating from a meter in the pair collides with a simultaneous transmission of information emanating from the other meter in the pair.

4. Method according to claim 3, **characterised in that** the risk metric of a pair of meters is dependent on a number of common nodes between the two meters in the pair on a path used by each meter in the pair for communicating with the concentrator and a relative position of each common node in said path.

5. Method according to claim 4, **characterised in that**, for each meter in the class, the risk score of said meter is a mean of the risk metric calculated for each pair of meters in which said meter is involved.

6. Method according to claim 5, **characterised in that** the predetermined threshold value is a mean of the risk scores.

7. Method according to any of claims 3 to 6, at each updating of the list, the meter to which the response to the request for information or the expiry of a predetermined maximum response time relates is removed from the class (426) and the risk scores are recalculated (413) for the remaining meters in the class, taking into account the removal of said meter from the class.

8. Method according to claim 2, **characterised in that**, in each class, the meters are furthermore classified in at least two subclasses, a first subclass comprising meters associated with risk information below a first predetermined risk threshold and a second subclass comprising meters associated with risk information above a second predetermined risk threshold, the list comprising at least one meter in each subclass as long as each subclass comprises at least one meter to be read and **in that**, on updating, the list being updated by replacing a meter in the list with another meter in the same subclass as long as there remain meters to be read in said subclass.

9. Method according to claim 8, **characterised in that** the risk information associated with a meter, referred to as the first meter, comprises a value representing a density of meters in the vicinity of said first meter and/or a value representing a number of intermediate nodes between said first meter and said concentrator, each intermediate node being a meter relaying frames from the first meter to the concentrator.

10. Method according to claim 8 or claim 9, **characterised in that** the list comprises a number of meters for each subclass proportional to a number of meters in the class belonging to said subclass.

**11.** Method according to claim 8 or claim 9, **characterised in that** the first and second risk thresholds are defined so as to have the same number of meters in each subclass and the list comprises the same number of meters in each subclass.

**12.** Method according to any of claims 9 to 11, **characterised in that** the meters are ordered in each subclass by order of values representing a decreasing density of meters and/or by order of values representing a decreasing number of intermediate nodes, and, when the list or each updating of the list is defined, the meters in a subclass are taken in their order of appearance in said subclass.

**13.** Device configured to implement a method for reading information from a set of electricity meters, referred to as meters, connected by an electricity supply network (1) to a data concentrator (10), referred to as a concentrator, with which said meters communicate by powerline, **characterised in that** the device comprises:

obtaining means for obtaining (410) information representing a set of meters classified in a plurality of classes, a first class comprising meters for which no information has been collected during the execution of said method preceding a current execution, and a plurality of second classes containing meters according to a rate of response to requests for information transmitted by said concentrator, the second classes being ordered by decreasing order of response rate;

running-through means for running through (412), for a predefined period fixing a time allocated for making the reading of the meters in said set, each class one by one by increasing order of classes, passing from a class currently being read to a new class when there no longer remain any meters to be read in the class currently being read; and means executed for each class comprising:

definition means for defining (417; 423) a list of a predefined number of meters in the class, each meter in the list being associated with information representing a topology of the network in a zone comprising said meter having an influence on a risk of failure of the transmissions of information by said meter, referred to as risk information, said list satisfying a predetermined condition such that at least one of the meters in the list is associated with risk information below a predetermined threshold;

transmission means for transmitting a request for information to each meter following insertion thereof in said list; and

means for updating the list, executed for each meter in the list, on reception (425) of a response to a request for information concerning said meter or at the expiry of a predefined maximum response time concerning said meter, the list being updated (426) by replacing said meter in the list with another meter in the class so that the updated list satisfies the predetermined condition.

**14.** Device according to claim 13, **characterised in that** the plurality of second classes comprises a second class comprising meters having a rate of response to requests for information transmitted by said concentrator higher than a predetermined reference level and a third class comprising meters having a rate of response to the requests for information transmitted by said concentrator below or equal to said predetermined reference rate.

**15.** Computer program, **characterised in that** it comprises instructions for the implementation, by a device, of the method according to any of claims 1 to 12 when said program is executed by a processor of said device.

**16.** Storage means, **characterised in that** they store a computer program comprising instructions for the implementation, by a device, of the method according to any of claims 1 to 12 when said program is executed by a processor of said device.

Fig. 1

Fig. 2

Obtention de N classes
de compteurs ⟿310

n=0 ⟿311

n<N ou durée de
relevé non
dépassée? ⟿312

non → FIN ⟿321

oui

obtention sous-classes ⟿313

définition d'une liste de
M compteurs ⟿314

Envoi demandes
d'informations ⟿315

n=n+1 ⟿317

Temps
dépassé
ou
réception
réponse? ⟿3161 ⟿316

oui

Envoi demandes
d'informations ⟿3163

Remplacement? ⟿3162

oui

non

Fig. 3

Fig. 4

**EP 3 656 131 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20140077970 A
- FR 2871981
- US 2015296277 A